# EUROPÄISCHE PATENTSCHRIFT

(11) **EP 3 745 090 B1**
(45) Veröffentlichungstag und Bekanntmachung des Hinweises auf die Patenterteilung: **14.07.2021**
(21) Anmeldenummer: 19176650.0
(22) Anmeldetag: 27.05.2019
(51) Int. Cl.: G01D 5/347

(54) **LICHTQUELLE SOWIE VERFAHREN ZU DEREN HERSTELLUNG UND POSITIONSMESSEINRICHTUNG MIT EINER LICHTQUELLE**
LIGHT SOURCE AND METHOD FOR PRODUCING THE SAME AND POSITION MEASURING DEVICE COMPRISING A LIGHT SOURCE
SOURCE LUMINEUSE AINSI QUE SON PROCÉDÉ DE FABRICATION ET DISPOSITIF DE MESURE DE LA POSITION DOTÉ D'UNE SOURCE LUMINEUSE

(43) Veröffentlichungstag der Anmeldung: 02.12.2020
(73) Patentinhaber: Dr. Johannes Heidenhain GmbH, 83301 Traunreut (DE)
(72) Erfinder: GÖHRE, Jens-Martin, 83362 Surberg (DE); HOLLSTEIN, Kai, 86551 Aichach (DE)

(56) Entgegenhaltungen:
- EP-A1- 1 993 148
- US-A1- 2013 163 627
- US-A1- 2014 112 363

## Beschreibung

### BEZEICHNUNG DER ERFINDUNG

Lichtquelle sowie Verfahren zu deren Herstellung und Positionsmesseinrichtung mit einer Lichtquelle
Die Erfindung betrifft eine Lichtquelle für eine Sensoreinheit einer Positionsmesseinrichtung gemäß dem Anspruch 1. Ferner betrifft die Erfindung ein Verfahren zur Herstellung einer derartigen Lichtquelle gemäß dem Anspruch 7 sowie eine Positionsmesseinrichtung mit einer Lichtquelle gemäß dem Anspruch 11.

### GEBIET DER TECHNIK

Positionsmesseinrichtungen werden beispielsweise als Winkelmesseinrichtungen oder als Drehgeber zur Bestimmung der Winkellage zweier relativ zueinander drehbarer Maschinenteile verwendet. Darüber hinaus sind Längenmesseinrichtungen bekannt, bei denen eine lineare Verschiebung zweier relativ zueinander verschiebbarer Maschinenteile gemessen wird. Winkelmesseinrichtungen wie auch Längenmesseinrichtungen weisen üblicherweise Sensoreinheiten auf, die relativ zu den Sensoreinheiten bewegbare Bauteile, etwa Winkelskalierungen oder Längenskalierungen beziehungsweise Maßstäbe abtasten und positionsabhängige Signale erzeugen.

Bei optischen Messeinrichtungen sind häufig Lichtquellen und Fotodetektoren auf einer Leiterplatte einer optischen Sensoreinheit montiert. Mit einem Luftspalt der Leiterplatte gegenüber liegend befindet sich eine optische Skalierung. Nach bekannten Prinzipien können dann von der Position abhängige Signale erzeugt werden.

Häufig werden derartige Messeinrichtungen beziehungsweise Messgeräte für elektrische Antriebe zur Bestimmung der Relativbewegung beziehungsweise der Relativlage von entsprechenden Maschinenteilen eingesetzt. In diesem Fall werden die erzeugten Positionswerte einer Folgeelektronik zur Ansteuerung der Antriebe über eine entsprechende Schnittstellenanordnung zugeführt.

### STAND DER TECHNIK

In der DE 10 2017 112 223 A1 wird ein Halbleiterlaser-Bauteil beschrieben, das über eine Verbindungsschicht bestromt werden kann.

Aus der US 2013/0163627 A1 und der US2014/112363 A1 ist ein Beleuchtungsmodul bekannt, welches über einen Bond-Draht und einer rückseitigen Anschlussanordnung elektrisch kontaktiert ist.

### ZUSAMMENFASSUNG DER ERFINDUNG

Der Erfindung liegt die Aufgabe zugrunde eine Lichtquelle für eine Sensoreinheit einer Positionsmesseinrichtung zu schaffen, die hochwertig ist und für den genannten Zweck optimiert ist.

Zudem soll durch die Erfindung ein Verfahren zur Herstellung einer Lichtquelle geschaffen werden, durch das qualitativ hochwertige Lichtquellen wirtschaftlich herstellbar sind.

Weiterhin wird durch die Erfindung eine Positionsmesseinrichtung geschaffen, durch die eine präzise Positionsmessung zuverlässig möglich ist.

Diese Aufgaben werden erfindungsgemäß durch die Merkmale des Anspruches 1 beziehungsweise durch die Merkmale der Ansprüche 7 und 11 gelöst.

Demnach umfasst die Lichtquelle für eine Sensoreinheit einer Positionsmesseinrichtung ein elektrisch leitfähiges Substrat, welches eine erste Fläche und weitere Flächen aufweist, wobei zumindest zwei der weiteren Flächen relativ zur ersten Fläche geneigt oder versetzt angeordnet sind. Weiterhin umfasst die Lichtquelle einen Halbleiterschichtaufbau, der zum Emittieren von Licht bestimmt ist und auf beziehungsweise der ersten Fläche aufgebracht ist sowie eine elektrisch leitende Schicht, welche das Substrat an den zwei der weiteren Flächen des Substrats elektrisch kontaktiert. Die Lichtquelle umfasst zudem einen ersten elektrischen Anschluss und einen zweiten elektrischen Anschluss. Der erste elektrische Anschluss ist mit der elektrisch leitenden Schicht verbunden und der zweite elektrische Anschluss ist mit dem Halbleiterschichtaufbau verbunden, so dass bei Anlegen einer elektrischen Spannungsdifferenz an den beiden Anschlüssen durch den Halbleiterschichtaufbau an einer ersten Seite der Lichtquelle Licht mit orthogonaler Richtungskomponente zur ersten Fläche emittierbar ist. Außerdem sind beide Anschlüsse an der ersten Seite der Lichtquelle angeordnet.

Der Begriff geneigt kann im Folgenden so verstanden werden, dass die jeweiligen Normalenvektoren der geneigten weiteren Flächen eine andere Richtung aufweisen als der Normalenvektor der ersten Fläche. Zueinander geneigte Flächen sind Flächen, die insbesondere nicht parallel zueinander orientiert sind.

Als elektrischer Anschluss kann im Folgenden beispielsweise ein Leiterzug verstanden werden, der mit der elektrisch leitenden Schicht oder mit dem Halbleiterschichtaufbau verbunden ist oder ein entsprechend zugängliches Pad oder eine Anschlussfläche.

In weiterer Ausgestaltung der Erfindung kontaktiert die elektrisch leitende Schicht das Substrat elektrisch an vier der weiteren Flächen. Insbesondere können diese vier der weiteren Flächen orthogonal zur ersten Fläche angeordnet sein.

Vorteilhafterweise kontaktiert die elektrisch leitende Schicht das Substrat elektrisch an fünf der weiteren Flächen.

Mit Vorteil weist das Substrat eine quaderförmige Form auf.

In weiterer Ausgestaltung der Erfindung ist an der elektrisch leitenden Schicht ein Kühlkörper angeordnet.

Vorteilhafterweise ist das Substrat mit der elektrisch leitenden Schicht in einer ersten Vergussmasse eingebettet.

Die Lichtquelle weist insbesondere nur elektrische Kontaktierungen auf, bei denen keine Drähte oder dergleichen verwendet werden. Insbesondere kann auf ein Wire-Bonding beziehungsweise auf ein Drahtbonden verzichtet werden.

Gemäß einem weiteren Aspekt umfasst die Erfindung ein Verfahren zur Herstellung einer Lichtquelle für eine Sensoreinheit einer Positionsmesseinrichtung mit folgenden Schritten:
Bereitstellen eines Substrats, welches eine erste Fläche und weitere Flächen beispielsweise eine zweite Fläche, eine dritte Fläche, eine vierte Fläche, eine fünfte Fläche und eine sechste Fläche aufweist, wobei zumindest zwei dieser weiteren Flächen relativ zur ersten Fläche geneigt oder versetzt angeordnet sind. Auf der ersten Fläche ist ein Halbleiterschichtaufbau aufgebracht.

Aufbringen einer elektrisch leitenden Schicht, auf den zumindest zwei der weiteren Flächen, so dass die elektrisch leitende Schicht das Substrat elektrisch kontaktiert. Diesem Schritt kann eine Vorbeschichtung etwa ein Bedampfen oder Sputtern beispielsweise mit einen Haftvermittler, einer elektrisch leitenden Startschicht oder dergleichen vorausgehen.

Herstellen eines ersten elektrischen Anschlusses und eines zweiten elektrischen Anschluss, in einer Weise, dass
der erste elektrische Anschluss mit der elektrisch leitenden Schicht elektrisch verbunden wird und
der zweite elektrische Anschluss mit dem Halbleiterschichtaufbau elektrisch verbunden wird, so dass
bei Anlegen einer elektrischen Spannungsdifferenz an den Anschlüssen durch den Halbleiterschichtaufbau an einer ersten Seite der Lichtquelle Licht mit orthogonaler Richtungskomponente zur ersten Fläche emittierbar ist, wobei beide Anschlüsse an einer ersten Seite der Lichtquelle angeordnet sind.

Im einfachsten Fall kann der erste elektrische Anschluss und / oder der zweite elektrische Anschluss ein Pad oder eine frei gelegte Fläche sein.

Mit Vorteil wird der Halbleiterschichtaufbau vor dem Aufbringen der elektrisch leitenden Schicht auf einem ersten Hilfsträger befestigt, so dass der Halbleiterschichtaufbau zwischen der ersten Fläche des Substrats und dem ersten Hilfsträger angeordnet ist.

In weiterer Ausgestaltung des Verfahrens wird die elektrisch leitende Schicht auch auf den ersten Hilfsträger aufgebracht.

Vorteilhafterweise wird die elektrisch leitende Schicht durch einen Galvanisierungsprozess aufgebracht.

Gemäß einem weiteren Aspekt umfasst die Erfindung eine Positionsmesseinrichtung, welche ihrerseits eine Sensoreinheit und ein relativ zur Sensoreinheit bewegbares Bauteil mit einer Skalierung umfasst. Die Sensoreinheit umfasst die Lichtquelle und einen Fotodetektor.

Mit Vorteil weist der Fotodetektor eine fotoempfindliche Fläche auf, wobei die erste Seite der Lichtquelle und die fotoempfindliche Fläche an derselben Seite der Sensoreinheit angeordnet sind.

In weiterer Ausgestaltung der Erfindung ist das bezüglich der Sensoreinheit bewegbare Bauteil relativ zur Sensoreinheit drehbar und die Skalierung ist als eine Winkelskalierung ausgestaltet.

Alternativ kann die Positionsmesseinrichtung derart aufgebaut sein, dass das Bauteil relativ zur Sensoreinheit linear verschiebbar ist und die Skalierung als eine Längenskalierung ausgestaltet ist.

Vorteilhafterweise ist das Bauteil relativ zur Sensoreinheit linear verschiebbar und die Skalierung als eine Längenskalierung ausgestaltet.

Die Skalierung kann also als Winkel- oder Längenskalierung ausgestaltet sein und zu einer inkrementalen oder absoluten Positionsmessung eingerichtet sein. Unter dem Begriff Skalierung ist ein Körper zu verstehen, der eine inkrementale oder absolute Teilung aufweist und häufig auch als Maßverkörperung bezeichnet wird.

In Weiterbildung der Positionsmesseinrichtung ist das Bauteil relativ zur Sensoreinheit drehbar und die Skalierung ist als eine Winkelskalierung ausgestaltet.

Vorteilhafte Ausbildungen der Erfindung entnimmt man den abhängigen Ansprüchen.

Weitere Einzelheiten und Vorteile der erfindungsgemäßen Lichtquelle und des erfindungsgemäßen Verfahrens beziehungsweise der Positionsmesseinrichtung ergeben sich aus der nachfolgenden Beschreibung zweier Ausführungsbeispiele anhand der beiliegenden Figuren.

### KURZE BESCHREIBUNG DER ZEICHNUNGEN

Es zeigen die
- Figur 1: eine Schnittdarstellung durch ein Substrat mit einem Halbleiterschichtaufbau und einen ersten Hilfsträger in einer ersten Herstellungsphase einer Lichtquelle,
- Figur 2: eine Draufsicht auf eine Anordnung gemäß der Figur 1,
- Figur 3: eine Schnittdarstellung in einer darauffolgenden Herstellungsphase der Lichtquelle,
- Figur 4: eine Schnittdarstellung in einer späteren Herstellungsphase der Lichtquelle,
- Figur 5: eine Schnittdarstellung in einer darauffolgenden Herstellungsphase der Lichtquelle mit einem Kühlkörper,
- Figur 6: eine Schnittdarstellung in einer darauffolgenden Herstellungsphase der Lichtquelle nach Aufbringen einer ersten Vergussmasse,
- Figur 7: eine Schnittdarstellung der Lichtquelle nach Entfernung des ersten Hilfsträgers,
- Figur 8: eine Schnittdarstellung der Lichtquelle nach einem späteren Herstellungsschritt,
- Figur 9: eine Schnittdarstellung der Lichtquelle nach einem späteren Herstellungsschritt mit hergestellten Anschlüssen,
- Figur 10: eine Seitenansicht auf eine Sensoreinheit in einer frühen Herstellungsphase,
- Figur 11: eine Schnittdarstellung auf eine Sensoreinheit in einer darauffolgenden Herstellungsphase,
- Figur 12: eine Schnittdarstellung einer Sensoreinheit in einer darauffolgenden Herstellungsphase,
- Figur 13: eine Seitenansicht einer Positionsmesseinrichtung
- Figur 14: eine Schnittdarstellung durch einen ersten Hilfsträger in einer ersten Herstellungsphase einer Lichtquelle gemäß einem zweiten Ausführungsbeispiel,
- Figur 15: eine Schnittdarstellung durch ein Substrat mit einem Halbleiterschichtaufbau und einen ersten Hilfsträger in einer ersten Herstellungsphase einer Lichtquelle gemäß dem zweiten Ausführungsbeispiel,
- Figur 16: eine Schnittdarstellung der Lichtquelle nach einem späteren Herstellungsschritt mit hergestellten Anschlüssen gemäß dem zweiten Ausführungsbeispiel.

### BESCHREIBUNG DER AUSFÜHRUNGSFORMEN

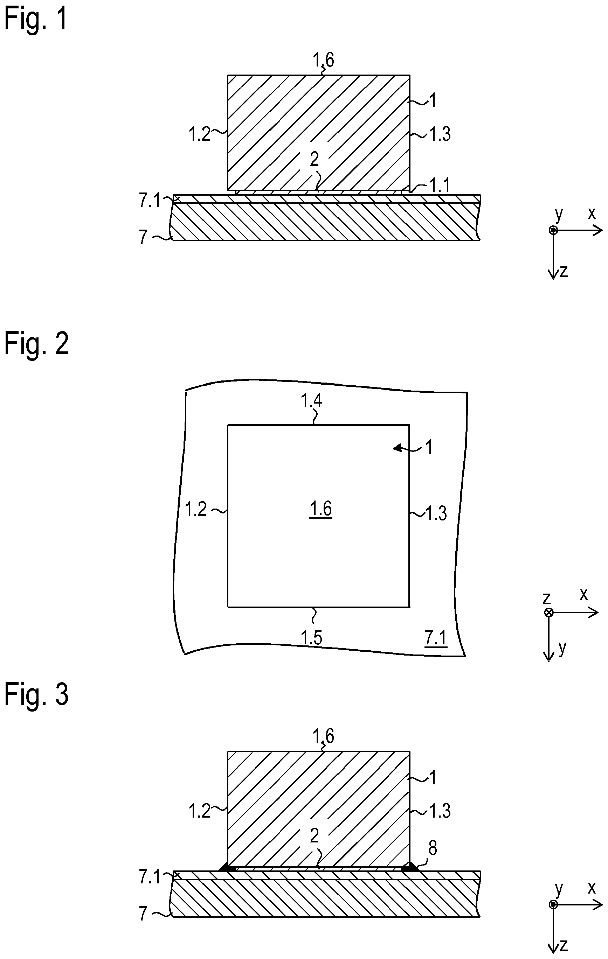

Gemäß einem Ausführungsbeispiel wird zunächst ein Substrat 1, auf welchem ein Halbleiterschichtaufbau 2 angeordnet ist, wie in der Figur 1 gezeigt bereitgestellt. Das Substrat 1 hat hier eine quaderförmige Gestalt und weist gemäß den Figuren 1 und 2 eine erste Fläche 1.1 auf, auf welcher der Halbleiterschichtaufbau 2 aufgebracht ist und die parallel zum Halbleiterschichtaufbau 2 orientiert ist. Die erste Fläche 1.1 erstreckt sich in den Figuren in einer x,y-Ebene. Gleiches gilt für den Halbleiterschichtaufbau 2.

Außerdem umfasst das Substrat 1 weitere Flächen auf, nämlich eine zweite Fläche 1.2, eine dritte Fläche 1.3, eine vierte Fläche 1.4 und eine fünfte Fläche 1.5 auf, die nicht parallel zum Halbleiterschichtaufbau 2, also geneigt (hier um 90°) zur ersten Fläche 1.1 orientiert sind. Zudem weist das Substrat 1 eine sechste Fläche 1.6 auf, die (bezüglich einer z-Richtung) versetzt und parallel zur ersten Fläche 1.1 orientiert ist. Somit weist also das Substrat 1 eine erste Fläche 1.1 und weitere Flächen 1.2 bis 1.6 auf, wobei die weiteren Flächen 1.2 bis 1.6 relativ zur ersten Fläche 1.1 geneigt (Flächen 1.2 bis 1.5) oder versetzt (Fläche 1.6) angeordnet sind. Das Substrat 1 ist aus elektrisch leitfähigem Material hergestellt, im vorgestellten Ausführungsbeispiel aus Silizium und der Halbleiterschichtaufbau 2 ist in elektrischem Kontakt zum Substrat 1, etwa unter Verwendung eines elektrisch leitenden Klebers. Der Halbleiterschichtaufbau 2 hat die Eigenschaft, dass durch diesen bei Anlegen einer elektrischen Spannungsdifferenz Licht emittierbar ist.

Eine Vielzahl von derartigen Baugruppen, bestehend aus jeweils einem Halbleiterschichtaufbau 2 und einem Substrat 1, werden mit Hilfe eines Pick-and-Place-Prozesses auf einem ersten Hilfsträger 7, der im vorgestellten Ausführungsbeispiel eine Klebeschicht 7.1 umfasst, befestigt, insbesondere aufgeklebt. Die Baugruppen sind danach so angeordnet, dass jeweils der Halbleiterschichtaufbau 2 dem ersten Hilfsträger 7 zugewandt ist. In den Figuren ist beispielhaft eine einzige derartige Baugruppe auf dem ersten Hilfsträger 7 gezeigt. Der erste Hilfsträger 7 kann aus Glas oder aus einem Metall hergestellt sein.

Im Anschluss daran wird gemäß der Figur 3 um den Halbleiterschichtaufbau 2 umlaufend eine isolierende Schicht 8 aufgebracht. Alternativ kann die umlaufende isolierende Schicht 8 auch schon vor dem Befestigen des mit dem Halbleiterschichtaufbaus 2 versehenen Substrats 1 auf dem ersten Hilfsträger 7 vorgenommen werden, beispielsweise indem die umlaufende isolierende Schicht 8 zuvor auf den ersten Hilfsträger 7 aufgebracht wird.

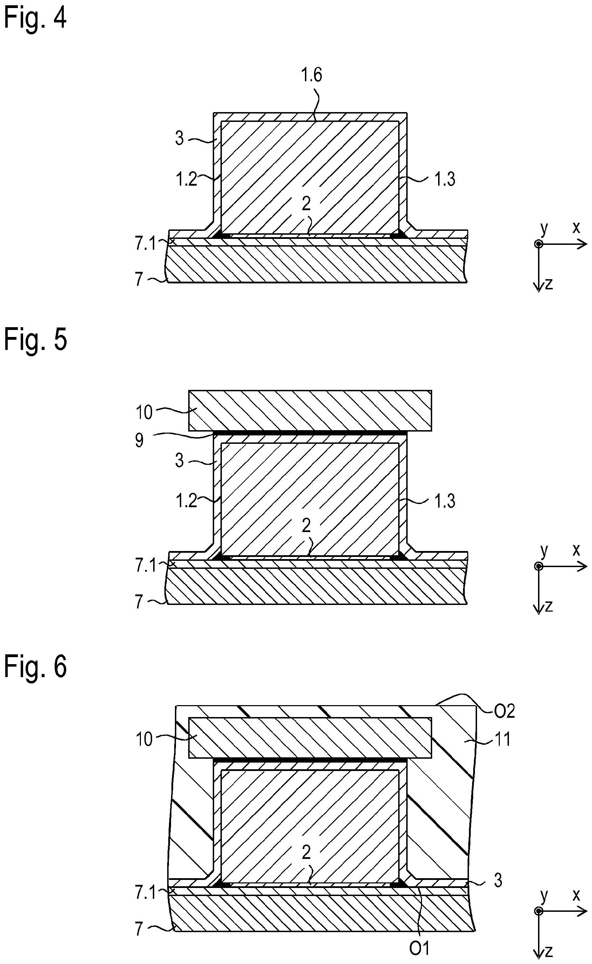

Gemäß der Figur 4 wird danach zur Vorbereitung eines Galvanisierungsprozesses die Oberfläche des Substrats 1 bedampft oder gesputtert und darauffolgend im eigentlichen Galvanisierungsprozess eine elektrisch leitfähige Schicht 3 aufgebracht. Diese elektrisch leitfähige Schicht 3 kann beispielsweise Kupfer umfassen. Auf diese Weise sind die weiteren Flächen 1.2 bis 1.6, also die zweite, die dritte, die vierte und die fünfte Fläche 1.2, 1.3, 1.4, 1.5 sowie die sechste Fläche 1.6 mit der elektrisch leitfähigen Schicht 3 überzogen, so dass das Substrat 1 in elektrischem Kontakt mit der elektrisch leitfähigen Schicht 3 ist. Weiterhin erstreckt sich die elektrisch leitfähige Schicht 3 bündig und parallel zum Halbleiterschichtaufbau 2 auf dem ersten Hilfsträger 7 beziehungsweise auf der Klebeschicht 7.1 (Figur 4).

Im vorgestellten Ausführungsbeispiel wird dann gemäß der Figur 5 ein thermischer Leitkleber 9 auf die sechste Fläche 1.6, die der ersten Fläche 1.1 mit dem Halbleiterschichtaufbau 2 gegenüber liegend angeordnet ist, aufgebracht und ein Kühlkörper 10 entsprechend fixiert. Optional kann auch auf das Vorsehen eines Kühlkörpers und dann natürlich auch auf den thermisch wirkenden Leitkleber verzichtet werden.

Im nächsten Herstellungsschritt wird eine erste Vergussmasse 11 (Figur 6) auf den ersten Hilfsträger 7 aufgebracht, so dass das Volumen um das Substrat 1 und den Kühlkörper 10 mit der ersten Vergussmasse 11 ausgefüllt ist. Es kann hier beispielsweise ein Dispenser oder eine Vergussanlage beziehungsweise eine Moldingeinrichtung verwendet werden um die erste Vergussmasse 11 aufzutragen. Im vorgestellten Ausführungsbeispiel kann durch die Hafteigenschaft der Klebeschicht 7.1 in Verbindung mit einem schonenden Vergussverfahren sichergestellt werden, dass keine Verschiebung des Substrats 1 während des Aufbringens der ersten Vergussmasse 11 auftritt.

Nach dem Vergießen und Aushärten der ersten Vergussmasse 11, die beispielsweise als ein Epoxid-Material mit Füllstoffen ausgestaltet sein kann, sind also die vergossenen Elemente durch die erste Vergussmasse 11 relativ zueinander fixiert. Auf diese Weise wurde ein Panel beziehungsweise ein Wafer erzeugt, das eine erste Oberfläche O1 aufweist, welches in dieser Herstellungsphase vom ersten Hilfsträger 7 abgedeckt ist, und das eine zweite Oberfläche O2 aufweist, die der ersten Oberfläche O1 (bezogen auf die z-Richtung) gegenüber liegend angeordnet ist.

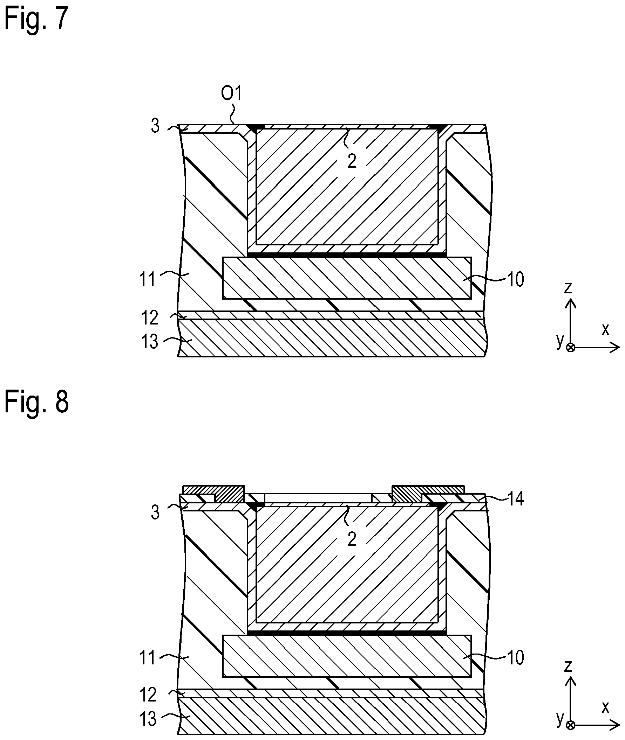

Als nächstes wird die zweite Oberfläche O2 plan geschliffen, also einem Schleifprozess unterzogen und danach die bisher hergestellte Anordnung beziehungsweise das Panel um 180° gedreht. In einem darauffolgenden Schritt wird die jeweilige geschliffene Oberfläche O2 der ersten Vergussmasse 11 gereinigt und mit Hilfe einer Klebeschicht 12 auf einem Trägerkörper 13 fixiert (Figur 7). In einem nachfolgenden Schritt der Herstellung wird der erste Hilfsträger 7 samt Klebeschicht 7.1 entfernt. Somit ist jeweils eine Seite des Halbleiterschichtaufbaus 2 bündig mit der ersten Oberfläche O1 der elektrisch leitfähigen Schicht 3 angeordnet. Darauffolgend werden die nun freigelegten Oberflächen des Halbleiterschichtaufbaus 2 und der elektrisch leitfähigen Schicht 3 gereinigt. Sofern ein geeignetes Verguss- beziehungsweise Molding-Verfahren angewendet wird, kann auch bezüglich der zweiten Oberfläche O2 auf den Schleifprozess verzichtet werden.

Alternativ kann das Herstellungsverfahren auch derart ausgestaltet sein, dass der erste Hilfsträger 7 samt Klebeschicht 7.1 nach dem Aufbringen der elektrischen leitfähigen Schicht 3 aber bereits vor dem Vergießen mit der ersten Vergussmasse 11 entfernt wird.

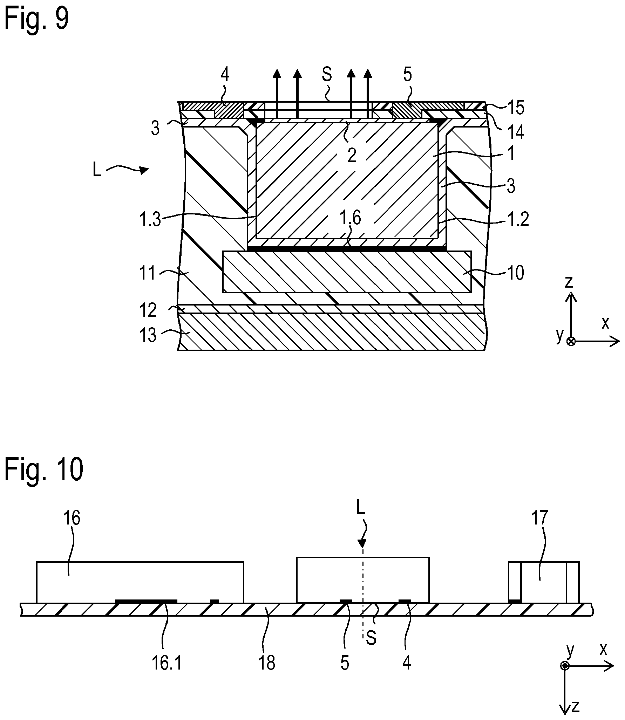

Gemäß der Figur 8 wird darauffolgend eine isolierende erste Schicht 14, insbesondere eine Schicht aus Polyimid, auf die erste Oberfläche O1, also auf die elektrisch leitfähige Schicht 3 und den Halbleiterschichtaufbau 2 aufgebracht. Diese erste Schicht 14 ist so ausgestaltet, dass Durchgangsöffnungen vorliegen. In diese Durchgangsöffnungen und teilweise auf die erste Schicht 14 wird elektrisch leitfähiges Material (hier Kupfer) aufgebracht. Auf das elektrisch leitfähige Material und auf die erste Schicht 14 wird eine zweite Schicht 15, die hier auch aus Polyimid besteht, aufgebracht. In die zweite Schicht 15 werden Öffnungen eingearbeitet, wobei das elektrisch leitfähige Material zugänglich und kontaktierbar ist, so dass gemäß der Figur 9 ein erster Anschluss 4 und ein zweiter Anschluss 5 entsteht.

Im Ergebnis liegt dann jeweils ein erster Anschluss 4 vor, der jeweils einen ersten Abschnitt und einen zweiten Abschnitt aufweist. In seinem ersten Abschnitt ist der erste Anschluss 4 durch die erste Schicht 14 hindurch geführt. Außerdem wird im ersten Abschnitt des Anschlusses 4, wie auch in der Figur 9 ersichtlich, ein elektrischer Kontakt zwischen dem ersten Anschluss 4 und der elektrisch leitfähigen Schicht 3 hergestellt.

Der zweite Abschnitt des ersten Anschlusses 4 umfasst ein so genanntes Anschlusspad, wobei der erste Anschluss 4 im zweiten Abschnitt auf der ersten Schicht 14 parallel zur zweiten Oberfläche O2 verläuft. Demnach ist dieser entsprechend der Dicke der ersten Schicht 14 von der elektrisch leitfähigen Schicht 3 beabstandet.

Zudem wird der zweite Anschluss 5 analog zur Erzeugung des ersten Anschlusses 4 hergestellt. Der zweite Anschluss 5 weist demnach auch einen ersten Abschnitt und einen zweiten Abschnitt auf und jeweils ein Anschlusspad, so dass ein elektrischer Kontakt zwischen dem Anschlusspad und dem Halbleiterschichtaufbau 2 hergestellt ist.

Auf die oben beschriebene Weise wurde ein Panel P beziehungsweise ein Wafer erzeugt, das eine Vielzahl von Lichtquellen L aufweist, wobei jede der Lichtquellen L ein Substrat 1 und einen Halbleiterschichtaufbau 2 umfasst. Zur Sicherstellung der Zuverlässigkeit jeder einzelnen Lichtquelle L wird nun an die Anschlüsse 4, 5 je eine Elektrode angelegt, so dass eine elektrische Spannungsdifferenz zwischen diesen vorliegt. Entsprechend fließt, verursacht durch die Spannungsdifferenz, ein elektrischer Strom über die Anschlüsse 4, 5 durch die elektrisch leitfähige Schicht 3, das Substrat 1 und durch den Halbleiterschichtaufbau 2.

Der Halbleiterschichtaufbau 2 emittiert im stromdurchflossenen Zustand, also auch im Testbetrieb, Licht. Entsprechend der Figur 9 emittiert die Lichtquelle L an ihrer ersten Seite S Licht, was durch die parallelen Pfeile dargestellt ist. Das Licht wird in einer Richtung ausgekoppelt, die eine z-Komponente aufweist (hier parallel zur z-Richtung), so dass also das Licht mit orthogonaler Richtungskomponente zur ersten Fläche 1.1 emittiert wird, folglich nicht in einer x,y-Ebene abgestrahlt wird. Das Licht wird von der ersten Fläche 1.1 weg emittiert, zumal das Substrat 1 lichtundurchlässig ist. Gegebenenfalls kann auch auf der ersten Fläche 1.1 eine Licht reflektierende Schicht aufgebracht sein beziehungsweise kann der Halbleiterschichtaufbau 2 eine Licht reflektierende Schicht aufweisen, so dass das mit einer z-Komponente gerichtete Licht intensiver emittiert wird. Die beiden Anschlüsse 4, 5 sind an der ersten Seite S der Lichtquelle L angeordnet.

Es wird ein temporärer Betrieb der Lichtquellen L durchgeführt, in dem die Lichtquellen L, beispielsweise eine Woche lang, bestromt werden. Häufig findet dieser Betrieb bei erhöhten Temperaturen in einem Klimaschrank statt. Am Ende des temporären Betriebs wird überprüft welche Lichtquelle L nicht ordnungsgemäß arbeitet, also kein oder zu wenig Licht emittiert und die betreffenden defekten Lichtquellen L werden entsprechend markiert.

Im Anschluss daran werden die Lichtquellen L vereinzelt. Zu diesem Zweck wird das Panel oder der Wafer, insbesondere die erste Vergussmasse 11 zertrennt. Im vorgestellten Ausführungsbeispiel werden mit Hilfe eines Trennschleiferfahrens mehrere zum Teil parallele Schnitte durchgeführt, die entlang der y-Richtung und der x-Richtung verlaufen. Defekte Lichtquellen L, die nach dem temporären Betrieb nicht hinreichend funktionsfähig sind, werden ausgesondert.

Zur Herstellung einer Sensoreinheit für ein Positionsmessgerät wird nachfolgend die Lichtquelle L, ein elektronisches Bauelement 16 und beispielsweise ein elektronischer Baustein 17, etwa ein Widerstand, gemäß der Figur 10 auf einem zweiten Hilfsträger 18 platziert. Der zweite Hilfsträger 18 ist beispielsweise als eine Klebefolie ausgestaltet. Das elektronische Bauelement 16, welches hier als IC-Chip ausgestaltet ist, umfasst Fotodetektoren 16.1 beziehungsweise ein oder mehrere Fotodetektorarrays, die Lichtsignale in elektrische Signale umwandeln. Weiterhin umfasst das elektronische Bauelement 16 Schaltungen zur Umwandlung dieser elektrischen Signale, insbesondere zur Digitalisierung der Signale und zu deren digitalen Weiterverarbeitung.

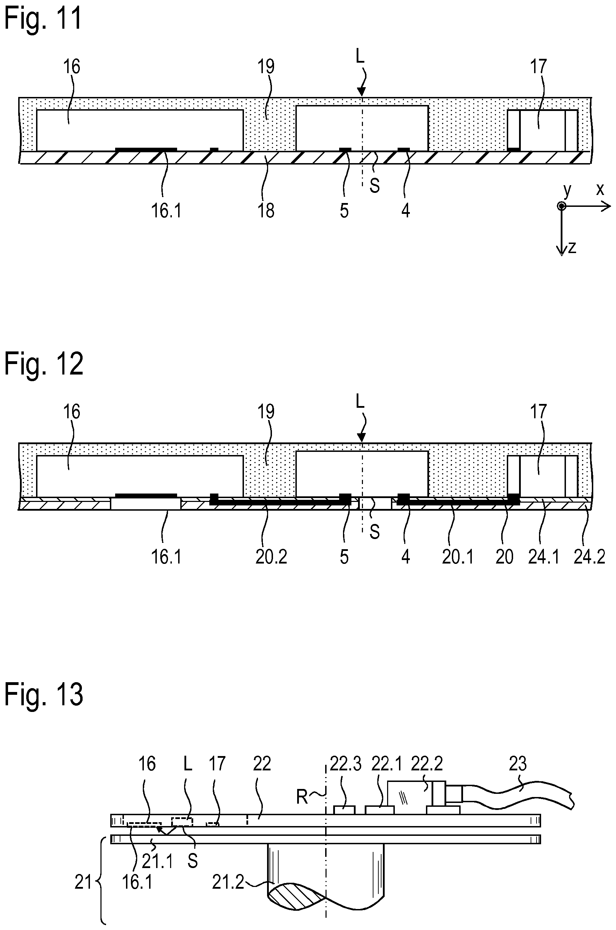

In einem darauffolgenden Schritt wird eine zweite Vergussmasse 19 (Figur 11) auf den zweiten Hilfsträger 18 aufgebracht, so dass das Volumen um das elektronische Bauelement 16, die Lichtquelle L und der elektronische Baustein 17 mit der zweiten Vergussmasse 19 ausgefüllt ist. Auch in diesem Prozessschritt kann beispielsweise ein Dispenser oder eine Vergussanlage beziehungsweise eine Moldingeinrichtung verwendet werden um die zweite Vergussmasse 19 aufzutragen. Die lichtempfindlichen Oberflächen der Fotodetektoren 16.1 sind nicht von der zweiten Vergussmasse 19 umgeben. Durch die ausgehärtete zweite Vergussmasse 19 sind unter anderem die Lichtquelle L und das elektronische Bauelement 16 relativ zueinander präzise fixiert. Insbesondere sind die lichtempfindlichen Oberflächen der Fotodetektoren 16.1 in z-Richtung bündig mit der lichtemittierenden Oberfläche O1 des Halbleiterschichtaufbaus 2 angeordnet.

Vorliegend kann unter dem Begriff Leiterzug eine Leiterbahn verstanden werden, die entweder auf einer Ebene verläuft oder im dreidimensionalen Raum. Insbesondere kann daher der Leiterzug auch eine Leiterbahn mit einer Durchkontaktierung beziehungsweise mit einem Via sein. Ein Leiterzug kann als eine Schicht ausgestaltet sein oder mehrere Schichten umfassen.

Im Anschluss daran wird gemäß der Figur 12 ein weiterer Schichtaufbau vorgenommen, insbesondere wird eine erste elektrisch isolierende Schicht 24.1 aufgebracht, auf welcher wiederum eine elektrisch leitende Schicht 20 aufgebracht wird. Diese elektrisch leitende Schicht 20 wird so bearbeitet beziehungsweise strukturiert, dass letztlich ein erster Leiterzug 20.1 und ein zweiter Leiterzug 20.2 gemäß der Figur 12 durch einen selektiven Leiterzugaufbau erzeugt werden. Der erste Leiterzug 20.1 ist mit dem ersten elektrischen Anschluss 4 elektrisch verbunden sowie mit einem Kontakt des elektronischen Bausteins 17. Der zweite Leiterzug 20.2 verbindet den zweiten elektrischen Anschluss 5 mit einem Kontakt des elektronischen Bauelements 16.

Auf die leitende Schicht 20 beziehungsweise auf den ersten Leiterzug 20.1 und den zweiten Leiterzug 20.2 werden danach eine elektrisch isolierende zweite Schicht 24.2 beziehungsweise eine Passivierungsschicht aufgebracht. Optional können auch noch weitere Schichten und weitere Leiterzüge erzeugt werden.

Die so konfigurierte Sensoreinheit gemäß der Figur 12 wird nun in eine Positionsmesseinrichtung eingebaut, insbesondere in einen Drehgeber beziehungsweise in ein Winkelmessgerät gemäß dem Prinzip-Bild der Figur 13. Die Positionsmesseinrichtung umfasst die erfindungsgemäße Sensoreinheit und ein relativ dazu bewegbares (hier relativ zur Sensoreinheit drehbares) Bauteil 21. Das Bauteil 21 besteht aus einer Skalierung 21.1, hier eine Winkelskalierung, und einer Welle 21.2. Im vorgestellten Ausführungsbeispiel umfasst die Skalierung 21.1 zumindest eine umlaufende Teilungs- oder Codespur, die mit einem Auflichtverfahren reflektiv abtastbar ist.

Alternativ kann die Lichtquelle L auch im Zusammenhang mit einer Durchlichtanordnung verwendet werden.

Die Sensoreinheit ist in einer im vorgestellten Ausführungsbeispiel im Wesentlichen scheibenförmigen Platte 22 beziehungsweise in einer Ausnehmung der Platte 22 montiert, die beispielsweise an einem Maschinenteil, etwa an einem Motorgehäuse, befestigt werden kann. Die Platte 22 ist hier als starrer Metallkörper beziehungsweise Metallring ausgestaltet. Die Platte 22 weist an zumindest einer Oberfläche eine isolierende Schicht auf, auf der Leiterbahnen und Kontaktierungsflächen hergestellt sind.

Üblicherweise dient das Bauteil 21.1 beziehungsweise die Winkelskalierung als Rotor und wird an einem um die Drehachse R drehbaren Maschinenteil befestigt. Dagegen bildet dann die Sensoreinheit den Stator der als Winkelmesseinrichtung ausgestalteten Positionsmesseinrichtung, so dass dieser an einem stehenden Maschinenteil fixiert wird. Im zusammengebauten Zustand der Positionsmesseinrichtung stehen sich das Bauteil 21.1 und die Sensoreinheit mit vergleichsweise geringem Luftspalt einander gegenüber, wobei der Luftspalt kleiner ist als in dem Prinzip-Bild der Figur 13 dargestellt.

Im Betrieb der Positionsmesseinrichtung emittiert die Lichtquelle L Licht, das gemäß dem in der Figur 13 angedeuteten Strahlengang von der Teilungsspur der Skalierung 21.1 reflektiert wird und auf die Fotodetektoren 16.1 fällt, die das einfallende Licht in Fotoströme beziehungsweise elektrische Signale umwandeln. Die Drehachse R verläuft durch das Zentrum des Bauteils 21 beziehungsweise der Skalierung 21.1. Bei einer Relativdrehung zwischen dem Bauteil 21 und der Sensoreinheit ist so in den Fotodetektoren 16.1 ein von der jeweiligen Winkelstellung abhängiges Signal erzeugbar.

Durch die oben beschriebene Bauweise der Sensoreinheit kann auf vergleichsweise einfache und kostengünstige Art eine Anordnung geschaffen werden, die eine genaue Einstellung des Spaltes zwischen den Fotodetektoren 16.1 und der Skalierung 21.1 beziehungsweise zwischen der Lichtquelle L und der Skalierung 21.1 erlaubt. Insbesondere ist bauartbedingt sichergestellt, dass die der Skalierung 21.1 zugewandte Oberfläche des elektronischen Bauelements 2 bündig mit der ersten Oberfläche O1 angeordnet ist. Durch die exakte Positionierung des elektronischen Bauelements 16 relativ zur Lichtquelle L kann nach erfolgter Montage beziehungsweise Fixierung der Lichtquelle L an einem Maschinenteil gewährleistet werden, dass das elektronische Bauelement 16, insbesondere die Fotodetektoren 16.1 und die Lichtquelle L präzise platziert sind.

Der auf der Platte 22 montierte Baustein 22.1 (beziehungsweise auf einer Kontaktierungsfläche) arbeitet als Auswerteelement für die Signale. In logischen Schaltungen auf dem Digitalteil des Bausteins 22.1 werden die Positionswerte resultierend aus der Abtastung der einzelnen Teilungsspuren ermittelt, beziehungsweise berechnet. Die Positionswerte können über das Kabel 23 an eine Folgeelektronik, beispielsweise eine Numerische Steuerung einer Maschine, übertragen werden. Eine mit der Sensoreinheit ausgestattete Positions- beziehungsweise Winkelmesseinrichtung dient demnach zur Erfassung einer Winkelposition zwischen der Sensoreinheit, die an einem Maschinenteil festlegbar ist und dem Bauteil 21 mit der Skalierung 21.1.

Auf der Platte 22 werden zudem beispielsweise ein Kabelanschluss 22.2 (hier ein Steckverbinder) und weitere elektronische Bauteile 22.3 rückseitig also auf der zweiten Fläche montiert. Demnach sind die weiteren elektronischen Bauteile 22.3 und der Kabelanschluss 22.2 auf einer zweiten Fläche der Platte 22 angeordnet, die der ersten Oberfläche O1 der Platte 22 gegenüber liegt.

Die Sensoreinheit gemäß der Anordnung in Figur 13 kann nun beispielsweise rückseitig mit elektrisch isolierendem Material umspritzt werden, so dass die in der Figur 13 oben liegende Fläche der Platte 22, die elektronischen Bauteile 22.1, 22.2 sowie der Kabelanschluss 22.2 zum Anschluss des Kabels 23 vor äußeren Einflüssen geschützt sind. Die Umspritzung kann in diesem Fall auch gleichzeitig als Zugentlastung für das Kabel 23 dienen.

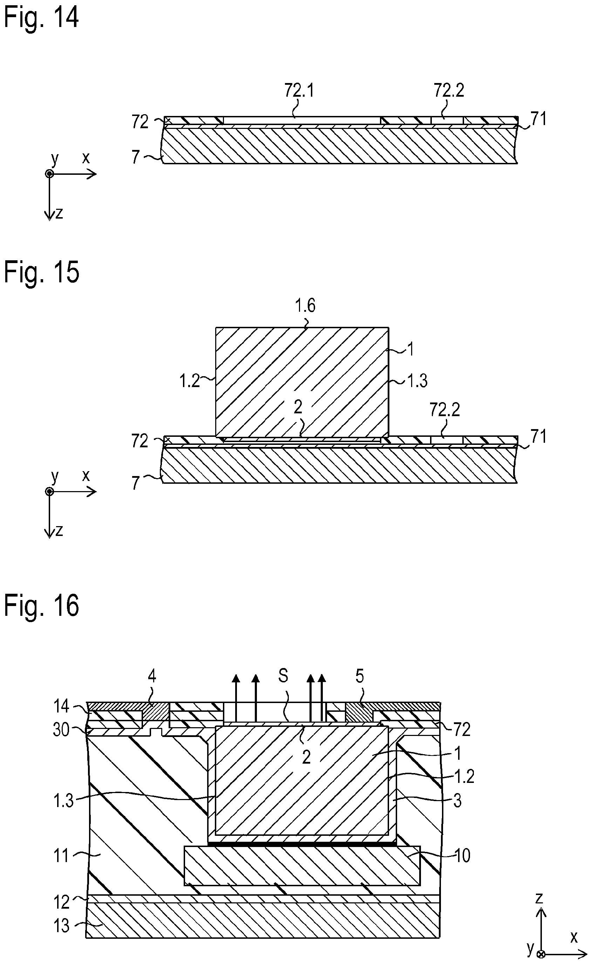

Anhand der Figuren 14, 15 und 16 wird ein zweites Ausführungsbeispiel erläutert. Gemäß diesem zweiten Ausführungsbeispiel wird auf dem ersten Hilfsträger 7 eine erste Hilfsschicht 71 aufgetragen, beispielsweise durch Sputtern oder Bedampfen oder als eine Klebeschicht. Im vorgestellten Ausführungsbeispiel wird als Material für die erste Hilfsschicht 71 Aluminium verwendet. Auf die erste Hilfsschicht 71 wird dann eine dielektrische Schicht 72 aufgebracht. Hier kann beispielsweise ein Phenolharz, welches Füllstoffe mit geringer Korngröße aufweist, als Material für die dielektrische Schicht 72 verwendet werden.

Im Anschluss daran wird die dielektrische Schicht 72 unter Verwendung eines fotochemischen Verfahrens so strukturiert, dass darin Öffnungen 72.1, 72.2 entstehen, wobei an den betreffenden Stellen die erste Hilfsschicht 71 freigelegt ist.

Danach wird der Halbleiterschichtaufbau 2 mit dem Substrat 1 mit Hilfe eines Pick-and-Place-Prozesses auf einem ersten Hilfsträger 7 so platziert, dass das Substrat 1 in die dielektrische Schicht 72 eingedrückt wird. Dabei werden die umlaufenden Kanten des Halbleiterschichtaufbaus 2 von der dielektrischen Schicht 72 umgeben, so dass der Halbleiterschichtaufbau 2 in diesem befestigt ist und der Randbereich zusätzlich passiviert ist aber von der ersten Hilfsschicht 71 beabstandet angeordnet ist.

Die weiteren Bearbeitungsprozesse zur Herstellung einer Lichtquelle gemäß dem zweiten Ausführungsbeispiel laufen im Prinzip ähnlich wie im ersten Ausführungsbeispiel ab. Allerdings weist im zweiten Ausführungsbeispiel eine elektrisch leitfähige Schicht 30 eine vom ersten Ausführungsbeispiel abweichende Gestalt auf. Gemäß der Figur 16 wird der Galvanisierungsprozess so vorgenommen, dass sich die elektrisch leitfähige Schicht 30 in die Öffnung 72.2 erstreckt. Weiterhin wird hier im Zuge der Herstellung der Lichtquelle der erste Hilfsträger 7 samt der ersten Hilfsschicht 71 vom weiteren Schichtaufbau getrennt. Somit wird also im Herstellungsprozess die erste Hilfsschicht 71 von der dielektrischen Schicht 72 getrennt, so dass die dielektrische Schicht 72 im Aufbau der Lichtquelle verbleibt.

Die elektrisch leitfähige Schicht 30 wird im Bereich der Öffnung 72.2 mit dem ersten Anschluss 4 kontaktiert. Der zweite Anschluss 5 kontaktiert den Halbleiterschichtaufbau 2 entsprechend dem ersten Ausführungsbeispiel.

## Patentansprüche

1. Lichtquelle (L) für eine Sensoreinheit einer Positionsmesseinrichtung umfassend
- ein elektrisch leitfähiges Substrat (1), welches eine erste Fläche (1.1) und weitere Flächen (1.2 bis 1.6) aufweist, wobei zumindest zwei der weiteren Flächen (1.2 bis 1.6) relativ zur ersten Fläche (1.1) geneigt oder versetzt angeordnet sind,
- einen Halbleiterschichtaufbau (2), der auf der ersten Fläche (1.1) aufgebracht ist,
- eine elektrisch leitende Schicht (3; 30), welche das Substrat (1) an den zwei der weiteren Flächen (1.2 bis 1.6) kontaktiert,
- einen ersten elektrischen Anschluss (4) und einen zweiten elektrischen Anschluss (5), wobei der erste elektrische Anschluss (4) mit der elektrisch leitenden Schicht (3; 30) verbunden ist und der zweite elektrische Anschluss (5) mit dem Halbleiterschichtaufbau (2) verbunden ist, so dass
bei Anlegen einer elektrischen Spannungsdifferenz an den Anschlüssen (4, 5) durch den Halbleiterschichtaufbau (2) an einer ersten Seite (S) der Lichtquelle (L) Licht mit orthogonaler Richtungskomponente zur ersten Fläche (1.1) emittierbar ist, wobei beide Anschlüsse (4, 5) an der ersten Seite (S) der Lichtquelle (L) angeordnet sind.

2. Lichtquelle (L) gemäß dem Anspruch 1, wobei die elektrisch leitende Schicht (3; 30) das Substrat (1) an vier der weiteren Flächen (1.2 bis 1.6) kontaktiert.

3. Lichtquelle (L) gemäß dem Anspruch 2, wobei die vier der weiteren Flächen (1.2 bis 1.6) orthogonal zur ersten Fläche (1.1) angeordnet sind.

4. Lichtquelle (L) gemäß dem Anspruch 1, wobei die elektrisch leitende Schicht (3; 30) das Substrat (1) an fünf der weiteren Flächen (1.2 bis 1.6) kontaktiert.

5. Lichtquelle (L) gemäß einem der vorhergehenden Ansprüche, wobei das Substrat (1) eine quaderförmige Form aufweist.

6. Lichtquelle (L) gemäß einem der vorhergehenden Ansprüche, wobei das Substrat (1) mit der elektrisch leitenden Schicht (3; 30) in einer ersten Vergussmasse (11) eingebettet ist.

7. Verfahren zur Herstellung einer Lichtquelle (L) für eine Sensoreinheit einer Positionsmesseinrichtung mit folgenden Schritten:
- Bereitstellen eines Substrats (1), welches eine erste Fläche (1.1) und weitere Flächen (1.2 bis 1.6) aufweist, wobei zumindest zwei der weiteren Flächen (1.2 bis 1.6) relativ zur ersten Fläche (1.1) geneigt oder versetzt angeordnet sind und ein Halbleiterschichtaufbau (2) auf der ersten Fläche (1.1) aufgebracht ist,
- Aufbringen einer elektrisch leitenden Schicht (3; 30), auf den zumindest zwei der weiteren Flächen (1.2 bis 1.6), so dass die elektrisch leitende Schicht (3; 30) das Substrat (1) kontaktiert,
- Herstellen eines ersten elektrischen Anschlusses (4) und eines zweiten elektrischen Anschluss (5), in einer Weise, dass der erste elektrische Anschluss (4) mit der elektrisch leitenden Schicht (3; 30) verbunden wird und
der zweite elektrische Anschluss (5) mit dem Halblelterschichtaufbau (2) verbunden wird, so dass bei Anlegen einer elektrischen Spannungsdifferenz an den Anschlüssen (4, 5) durch den Halbleiterschichtaufbau (2) an einer ersten Seite (S) der Lichtquelle (L) Licht mit orthogonaler Richtungskomponente zur ersten Fläche (1.1) emittierbar ist, wobei beide Anschlüsse (4, 5) an einer ersten Seite (S) der Lichtquelle (L) angeordnet sind.

8. Verfahren gemäß dem Anspruch 7, wobei der Halbleiterschichtaufbau (2) vor dem Aufbringen der elektrisch leitenden Schicht (3; 30) auf einem ersten Hilfsträger (7) befestigt wird, so dass der Halbleiterschichtaufbau (2) zwischen der ersten Fläche (1.1) des Substrats (1) und dem ersten Hilfsträger (7) angeordnet ist.

9. Verfahren gemäß dem Anspruch 8, wobei die elektrisch leitende Schicht (3; 30) auch auf den ersten Hilfsträger (7), welcher vor dem Herstellen des zweiten elektrischen Anschlusses (5) entfernt wird, aufgebracht wird.

10. Verfahren gemäß dem Anspruch 8 oder 9, wobei die elektrisch leitende Schicht (3; 30) durch einen Galvanisierungsprozess aufgebracht wird.

11. Positionsmesseinrichtung, umfassend eine Sensoreinheit und ein relativ zur Sensoreinheit bewegbares Bauteil (21) mit einer Skalierung (21.1), wobei die Sensoreinheit eine Lichtquelle (L) gemäß dem Anspruch 1 und einen Fotodetektor (2) umfasst.

12. Positionsmesseinrichtung gemäß dem Anspruch 11, wobei der Fotodetektor (16) eine fotoempfindliche Fläche (16.1) aufweist, wobei die erste Seite (S) der Lichtquelle (L) und die fotoempfindliche Fläche (16.1) an derselben Seite der Sensoreinheit angeordnet sind.

13. Positionsmesseinrichtung gemäß dem Anspruch 11 oder 12, wobei das Bauteil (21) relativ zur Sensoreinheit drehbar ist und die Skalierung (21.1) als eine Winkelskalierung ausgestaltet ist.

14. Positionsmesseinrichtung gemäß dem Anspruch 11 oder 12, wobei das Bauteil (21) relativ zur Sensoreinheit linear verschiebbar ist und die Skalierung (21.1) als eine Längenskalierung ausgestaltet ist.

## Claims

1. Light source (L) for a sensor unit of a position measuring device, comprising
- an electrically conductive substrate (1) having a first surface (1.1) and further surfaces (1.2 to 1.6), wherein at least two of the further surfaces (1.2 to 1.6) are arranged in a manner inclined or offset relative to the first surface (1.1),
- a semiconductor layer structure (2) applied on the first surface (1.1),
- an electrically conductive layer (3; 30), which contacts the substrate (1) at the two of the further surfaces (1.2 to 1.6),
- a first electrical connection (4) and a second electrical connection (5), wherein the first electrical connection (4) is connected to the electrically conductive layer (3; 30) and the second electrical connection (5) is connected to the semiconductor layer structure (2), such that, upon an electrical voltage difference being applied to the connections (4, 5), light is emittable with an orthogonal direction component with respect to the first surface (1.1) by means of the semiconductor layer structure (2) at a first side (S) of the light source (L), wherein both connections (4, 5) are arranged at the first side (S) of the light source (L).

2. Light source (L) according to Claim 1, wherein the electrically conductive layer (3; 30) contacts the substrate (1) at four of the further surfaces (1.2 to 1.6).

3. Light source (L) according to Claim 2, wherein the four of the further surfaces (1.2 to 1.6) are arranged orthogonally with respect to the first surface (1.1).

4. Light source (L) according to Claim 1, wherein the electrically conductive layer (3; 30) contacts the substrate (1) at five of the further surfaces (1.2 to 1.6).

5. Light source (L) according to any of the preceding claims, wherein the substrate (1) has a parallelepipedal shape,

6. Light source (L) according to any of the preceding claims, wherein the substrate (1) is embedded with the electrically conductive layer (3; 30) in a first potting compound (11).

7. Method for producing a light source (L) for a sensor unit of a position measuring device, comprising the following steps:
- providing a substrate (1) having a first surface (1.1) and further surfaces (1.2 to 1.6), wherein at least two of the further surfaces (1.2 to 1.6) are arranged in a manner inclined or offset relative to the first surface (1.1) and a semiconductor layer structure (2) is applied on the first surface (1.1),
- applying an electrically conductive layer (3; 30) on the at least two of the further surfaces (1.2 to 1.6), such that the electrically conductive layer (3; 30) contacts the substrate (1),
- producing a first electrical connection (4) and a second electrical connection (5) in such a way that
the first electrical connection (4) is connected to the electrically conductive layer (3; 30) and the second electrical connection (5) is connected to the semiconductor layer structure (2), such that,
upon an electrical voltage difference being applied to the connections (4, 5), tight is emittable with an orthogonal direction component with respect to the first face (1.1) by means of the semiconductor layer structure (2) at a first side (S) of the light source (L), wherein both connections (4, 5) are arranged at a first side (S) of the light source (L).

8. Method according to Claim 7, wherein the semiconductor layer structure (2) is secured on a first auxiliary carrier (7) before the electrically conductive layer (3; 30) is applied, such that the semiconductor layer structure (2) is arranged between the first surface (1.1) of the substrate (1) and the first auxiliary carrier (7).

9. Method according to Claim 8, wherein the electrically conductive layer (3; 30) is also applied to the first auxiliary carrier (7), which is removed before the second electrical connection (5) is produced,

10. Method according to Claim 8 or 9, wherein the electrically conductive layer (3, 30) is applied by means of an electroplating process.

11. Position measuring device, comprising a sensor unit and a component part (21) with a scaling (21.1), said component part being movable relative to the sensor unit, wherein the sensor unit comprises a light source (L) according to Claim 1 and a photodetector (2).

12. Position measuring device according to Claim 11, wherein the photodetector (16) has a photosensitive surface (16.1), wherein the first side (S) of the light source (L) and the photosensitive surface (16.1) are arranged at the same side of the sensor unit.

13. Position measuring device according to Claim 11 or 12, wherein the component part (21) is rotatable relative to the sensor unit and the scaling (21.1) is configured as an angle scaling.

14. Position measuring device according to Claim 11 or 12, wherein the component part (21) is linearly displaceable relative to the sensor unit and the scaling (21.1) is configured as a length scaling.

## Revendications

1. Source de lumière (L) pour une unité de capteur d'un dispositif de mesure de position, comprenant
- un substrat électriquement conducteur (1) qui présente une première surface (1.1) et d'autres surfaces (1.2 à 1,6), au moins deux des autres surfaces (1.2 à 1.6) étant disposées de manière inclinée ou décalée par rapport à la première surface (1.1),
- une structure de couche semi-conductrices (2) qui est appliquée sur la première surface (1.1),
- une couche électriquement conductrice (3 ; 30), qui est mise en contact avec le substrat (1) sur les deux surfaces parmi les autres surfaces (1.2 à 1.6),
- une première connexion électrique (4) et une deuxième connexion électrique (5), la première connexion électrique (4) étant reliée à la couche électriquement conductrice (3 ; 30), et la deuxième connexion électrique (5) étant reliée à la structure de couches semi-conductrices (2) de sorte que
lors de l'application d'une différence de tension électrique aux connexions (4, 5) par la structure de couches semi-conductrices (2) sur un premier côté (S) de la source de lumière (L), de la lumière ayant une composante directionnelle orthogonale à la première surface (1.1) peut être émise, les deux connexions (4, 5) étant disposées sur le premier côté (S) de la source de lumière (L).

2. Source de lumière (L) selon la revendication 1, dans laquelle la couche électriquement conductrice (3 ; 30) est mise en contact avec le substrat (1) sur quatre surfaces parmi les autres surfaces (1.2 à 1.6).

3. Source de lumière (L) selon la revendication 2, dans laquelle les quatre surfaces parmi les autres surfaces (1.2 à 1.6) sont disposées de manière orthogonale par rapport à la première surface (1.1).

4. Source de lumière (L) selon la revendication 1, dans laquelle la couche électriquement conductrice (3 ; 30) est mise en contact avec le substrat (1) sur cinq surfaces parmi les autres surfaces (1.2 à 1.6).

5. Source de lumière (L) selon l'une quelconque des revendications précédentes, dans laquelle le substrat (1) présente une forme parallélépipédique.

6. Source de lumière (L) selon l'une quelconque des revendications précédentes, dans laquelle le substrat (1) doté de la couche électriquement conductrice (3 ; 30) est incorporé dans une première masse de scellement (11).

7. Procédé de fabrication d'une source de lumière (L) pour une unité de capteur d'un dispositif de mesure de position, comprenant les étapes suivantes consistant à ;
- fournir un substrat (1) qui présente une première surface (1.1) et d'autres surfaces (1.2 à 1.6), au moins deux des autres surfaces (1.2 à 1.6) étant disposées de manière inclinée ou décalée par rapport à la première surface (1.1) et une structure de couches semi-conductrices (2) étant appliquée sur la première surface (1.1),
- appliquer une couche électriquement conductrice 3 ; 30) sur les au moins deux surfaces parmi les autres surfaces (1.2 à 1.6) de sorte que la couche électriquement conductrice (3 ; 30) est mise en contact avec le substrat (1),
- fabriquer une première connexion électrique (4) et une deuxième connexion électrique (5) de telle sorte que la première connexion électrique (4) est reliée à la couche électriquement conductrice (3 ; 30) et la deuxième connexion électrique (5) est reliée à la structure de couches semi-conductrices (2) de sorte que lors de l'application d'une différence de tension électrique aux connexions (4, 5) par la structure de couches semi-conductrices (2) sur un premier côté (S) de la source de lumière (L), de la lumière ayant une composante directionnelle orthogonale à la première surface (1.1) peut être émise, les deux connexions (4, 5) étant disposées sur un premier côté (S) de la source de lumière (L).

8. Procédé selon la revendication 7, dans lequel la structure de couches semi-conductrices (2), avant l'application de la couche électriquement conductrice (3 ; 30), est fixée à un premier support auxiliaire (7) de sorte que la structure de couches semi-conductrices (2) est disposée entre la première surface (1.1) du substrat (1) et le premier support auxiliaire (7).

9. Procédé selon la revendication 8, dans lequel la couche électriquement conductrice (3 ; 30) est appliquée aussi sur le premier support auxiliaire (7) qui est retiré avant la fabrication, de la deuxième connexion électrique (5).

10. Procédé selon la revendication 8 ou 9, dans lequel la couche électriquement conductrice (3 ; 3 est appliquée par un processus de galvanisation.

11. Dispositif de mesure de position, comprenant une unité de capteur et un composant (21) mobile par rapport à l'unité de capteur et doté d'une graduation (21.1), l'unité de capteur comprenant une source de lumière (L) selon la revendication 1 et un photodétecteur (2).

12. Dispositif de mesure de position selon la revendication 11, dans lequel le photodétecteur (16) présente une surface photosensible (16.1), le premier côté (S) de la source de lumière (L) et la surface photosensible (16.1) étant disposés sur le même côté de l'unité de capteur.

13. Dispositif de mesure de position selon la revendication 11 ou 12, dans lequel le composant (21) est pivotant par rapport à l'unité de capteur et la graduation (21.1) est configurée comme une graduation d'angle.

14. Dispositif de mesure de position selon la revendication 11 ou 12, dans lequel le dispositif (21) peut être déplacé de manière linéaire par rapport à l'unité de capteur et la graduation (21.1) est configurée comme une graduation de longueur.
